# EUROPEAN PATENT APPLICATION

(11) **EP 1 271 658 A1**
(43) Date of publication of application: **02.01.2003**
(21) Application number: 00810958.9
(22) Date of filing: 17.10.2000
(51) Int. Cl.: H01L 29/92

(54) **Ferroelectric film capacitor structure with selective doping**

(71) Applicant: Ecole Polytechnique Fédérale de Lausanne, 1015 Lausanne (CH)
(72) Inventor: Stolitchnov Igor, 1024 Ecublens (CH); Tagantsev Alexander, 1009 Pully (CH)
(74) Representative: Cronin, Brian Harold John

(57) **Abstract**

A ferroelectric film capacitor structure (FeCAP), in particular for memory applications, comprises a layer of doped ferroelectric material between facing electrodes having a varying/asymmetric doping profile, the concentration of the dopant in the ferroelectric material varying as a function of the distance from the electrodes. The ferroelectric material can be in particular a perovskite such as (Pb) (Zr,Ti)0₃ (PZT) and the dopant can be selected from Nb, Ta, La, Sr, Ca or their combinations. Advantageously, the concentration of dopant decreases near one or both interfaces of the ferroelectric material with the electrodes, the concentration of dopant, as a function of the distance from the electrodes, being typically up to 15% by weight of the ferroelectric material.

## Description

### Field of the Invention

This invention relates to ferroelectric film capacitor structures, known as FeCAPs, comprising a layer of doped ferroelectric material between facing electrodes, in particular for memory applications but also possibly for use in sensors, actuators, etc.

### Background of the Invention

Ferroelectric materials, in particilar ferroelectric perovkites e.g. (ZrₓTi₁₋ₓ)O₃ (PZT), possess a spontaneous polarization that can be reoriented with an applied electric field. Such ferroelectric thin film materials are of paramount interest for new non-volatile memory applications. Their benefits compared to conventional nonvolatile memories such as flash RAM and EEPROM are smaller cell size, higher operation speed, lower operation voltage and lower energy consumption. However, as of yet several reliability problems plague PZT thin films including polarization fatigue, imprint and retention losses.

Adding dopants to the standard composition of the ferroelectric material (PZT) is known as an efficient tool for control of various properties of FeCAPs for memory applications, and the influence of dopants on the properties of ferroelectric thin films is intensively studied worldwide in view of the great practical importance of this problem.

Specifically, Nb doping is known to be efficient for leakage conduction suppression, see the article "Control of Leakage Resistance in (Pb)(Zr,Ti)O₃ Thin Films by Donor Doping" by D.Dimos et al, in Journal of the American Ceramic Society, Vol. 77, No. 11, pp 3000-3005. This article also discusses La doping.

Sc or Na doping is reported to improve the polarization fatigue endurance, see the article "Acceptor Dopant Effects on Endurance of PZT Thin Films" by R.D.Klissurska et al, in Ferroelectrics, 1999, Vol. 225, pp171-178, which examined the effect of varying the dopant concentration in PZT thin films, and concluded that increasing the acceptor dopant concentration improves the films' endurance characteristics. See also US Patent 5,625,529, which discusses the effect of Sc doping on fatigue performance.

Nb, Ta or mixed La+Sr+Ca doping reduces polarization imprint and improves the retention characteristics, as disclosed in US Patents No 5,677,825 and 5,969,935.

US Patent No 5,858,451 describes a process for the production of ferroelectric powders from the PZT family of materials doped with metal donor ions of lanthanum and niobium.

US Patent No 5,888,659 describes donor doped perovskites for thin-film ferroelectric devices having increased leakage resistivity.

However, along with the positive effects, modification of the ferroelectric film composition by adding dopants also has a negative impact on some properties of the FeCAPs. Specifically, dopants typically result in a decrease of switching polarization, degradation of hysteresis properties and sometimes an increase of the time of switching.

Reduction of these unwanted effects is of high practical importance for memory applications.

### Summary of the Invention

The invention provides a ferroelectric film capacitor structure, in particular FeCAPs for memory applications, comprising a layer of doped ferroelectric material between facing electrodes having a varying (usually asymmetric) doping profile, the concentration of the dopant in the ferroelectric material varying as a function of the distance from the electrodes.

The invention is based on the observation that both the interface and bulk of the ferroelectric film play essential roles for the FeCAP performance. Varying/asymmetrical doping enables a selective control of the interface-determined properties without touching the bulk properties, and *vice versa*.

The ferroelectric material can be of perovskite structure, in particular (Pb)(Zr,Ti)O₃ (PZT) and the dopant can be selected from Nb, Ta, La, Sr, Ca or their combinations.

It is postulated that an interfacial interaction between the doping impurities and centers of the polarization domain nucleation is responsible for deterioration of the ferroelectric properties of the system due to added dopants. Hence the creation of "dopant-free" pure ferroelectric layer at least at one interface of the structure can substantially improve the its performance.

Advantageously, therefore, the concentration of dopant decreases near one of the interfaces of the ferroelectric material or possibly the concentration of dopant decreases near both interfaces of the ferroelectric material.

The concentration of dopant, as a function of the distance from the electrodes, is typically in the range 0 to 15% by weight of the ferroelectric material, the minimum concentration of dopant, when present, being about 0.5%.

The ferroelectric material is possibly composed of a plurality of film layers, each film layer being undoped or containing a selected quantity of the dopant such that, even allowing for some diffusion of the dopant between adjacent film layers, the concentration of the dopant in the resulting ferroelectric material varies as a function of the distance from the electrodes. Such ferroelectric material can conveniently be obtained by a method of chemical solution deposition (CSD) using precursors having no dopant, or selected dopant concentrations.

The typical top electrode materials are metals in particular platinum, and conductive oxides including RuO₂, IrO₂ and SrRuO₃ ("SRO").

The capacitor structures according to the invention can be incorporated into many types of memory device, in particular non-volatile memories, such as integrated memory cells comprising a plurality of the structures interconnected together, nonvolatile ferroelectric memories (FeRAM), Metal-Ferroelectric-Semiconductor Field Effect Transistors (MFS-FET) and so on. Further applications include sensors and actuators.

### Brief Description of the Drawings

The invention will be further described by way of an experimental example with reference to the accompanying drawings, in which:
Figures 1a, 1b and 1c show secondary ion Mass-Spectrometry (SIMS) profiles for 250nm PZT film, doped completely with 2% Nb (a) , with bottom layer doped (b), and top layer doped (c).
Figures 2a, 2b and 2c show hysteresis loops respectively for bulk doped samples, bottom layer doped samples and top layer doped samples;
Figures 3a, 3b and 3c show switching polarizationas a function of the number of cycles respectively for bulk doped samples, bottom layer doped samples and top layer doped samples;
Figure 4a to 4c show current-voltage curves respectively for bulk doped samples, bottom layer doped samples and top layer doped samples.
Figures 5a and 5b show breakdown curves respectively for bulk doped samples and asymmetrically doped samples;

### Detailed Description

The invention has been experimentally implemented by preparing a series of PZT films selectively doped with Nb in a concentration range from 1 to 5%.

The Nb-doped PZT films with 45/55 Zr/Ti ratio (PNZT films) were deposited in four layers by chemical solution deposition on platinized silicon wafers. Platinum top electrodes were sputtered onto the films via a nickel shadow mask and the wafers were post-annealed at 700°C in the rapid thermal annealing unit.

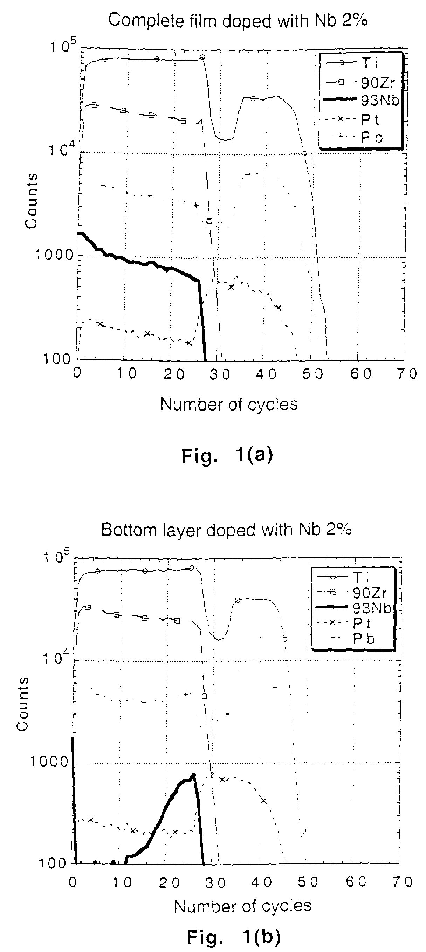

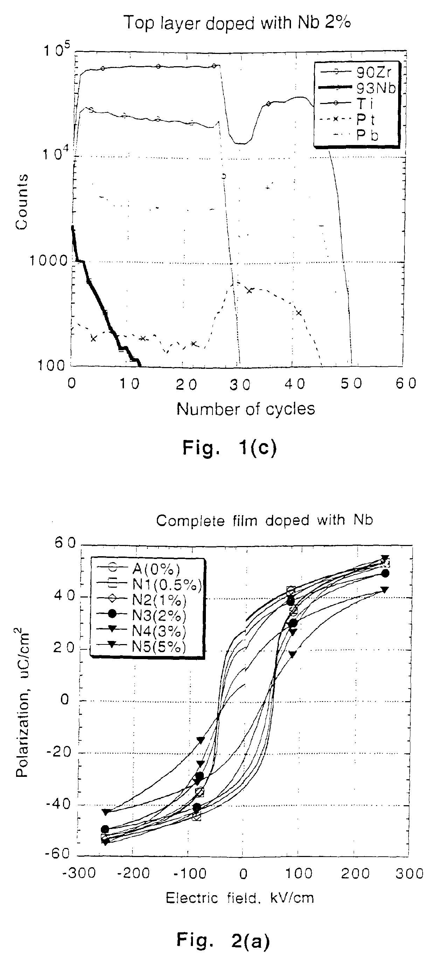

The film thickness was measured by profilometry and varied from 225 to 255 nm. All films are mainly (111) oriented, but this predominance decreases with increasing Nb concentration. Sixteen different samples were prepared, including one non-doped sample (A), five bulk-doped samples (N1, N2, N3, N4, N5), five bottom-layer-doped samples (N6, N7, N8, N9, N10), and five top-layer-doped samples (N11, N12, N13, N14, N-15). The Nb concentration in each doped series increases with increasing number and amounts to 0.5%, 1%, 2%, 3%, and 5% of the doped layer. In the case of asymmetrically doped films, only one out of four layers was doped, while the other three remained nominally undoped. SIMS analysis (Fig. 1) showed that in fact some of the dopant had diffused in both cases, but not beyond a third of the film. SEM and TEM imaging confirmed that the grain size was constant regardless of dopant distribution.

### Ferroelectric properties and fatigue

Ferroelectric hysteresis loops have been measured using conventional Sawyer-Tower circuit. The fatigue treatment was performed by square pulse 5OkHz AC voltage cycling with an amplitude of 250kV/cm. After every semi-decade of cycles the switching polarization is measured. These measurements continued until the film had been switched 10⁸ times, furnishing 17 values each for positive and negative Pᵣ. These values were plotted in dependence of switching cycles to evaluate the fatigue of the film's ferroelectric properties.

### Leakage conduction properties

The leakage conduction characteristics of the samples were ascertained by current-voltage (I-V) measurements in staircase mode. After polarizing the sample with a short DC pulse and a delay of several minutes to enable relaxation, a DC voltage is applied in successive steps of length 50 sec. and amplitude 0.2V. A programmable electrometer with built-in voltage source continually measures the leakage conduction and at the end of each step. For details of I-V curve measurements, see I. Stolichnov, A. Tagantsev, J. Appl. Phys., 84, 3216 (1998).

### Breakdown measurements

The breakdown measurements were performed at a constant current for each sample; for the measuring procedure, see I. Stolichnov et al. J. Appl. Phys. 87, 1925 (2000). Because low current densities lead to long measuring times, while high current densities break weak films far too rapidly to gain any data on their behavior, a current density of -10⁻⁴A/cm² was applied to all measured films but N5, which was measured at -2x10⁻⁵A/cm². Measuring the films at a constant current density made it possible to plot the voltage across the film as a function of total charge and time, the two being equivalent. Breakdown was defined as the first marked drop in voltage. Each film was measured about ten times, in order to ascertain the main trends. In order to reduce the statistical error, the breakdown measurements were performed on the smallest top electrode dot of 7.85x10⁻⁵cm², thereby minimizing the probability of encountering a defect.

### Discussion

### Hysteresis loops and fatigue

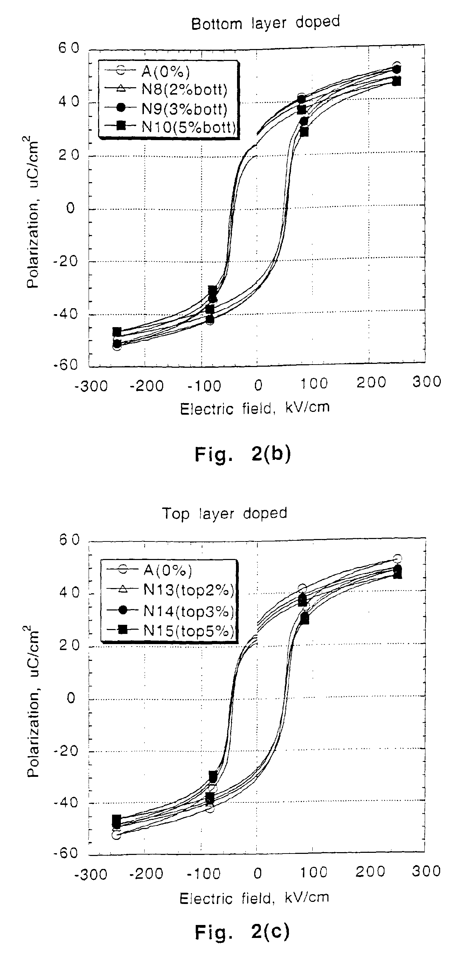

The results of the hysteresis loop measurements are presented in Figures 2a to 2c. While in Figure 2a the hysteresis loop for bulk doping clearly deteriorates with increasing dopant concentration, the deterioration is negligible in the case of the asymmetrically doped samples (Figs. 2b, 2c). The ability to retain polarization also decreases with increasing dopant concentration, as evidenced by the larger discontinuity between the beginning and end of the loop. The loops presented in Figures 2a to 2c correspond to the beginning of the fatigue measurements, however without being virgin loops.

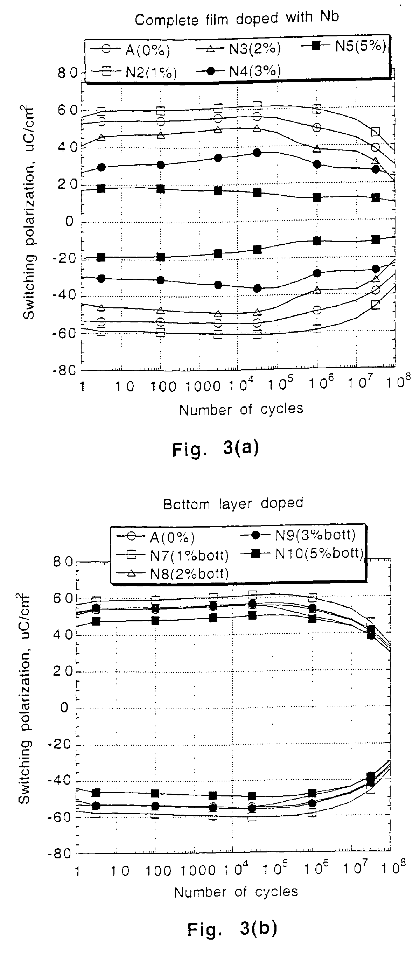

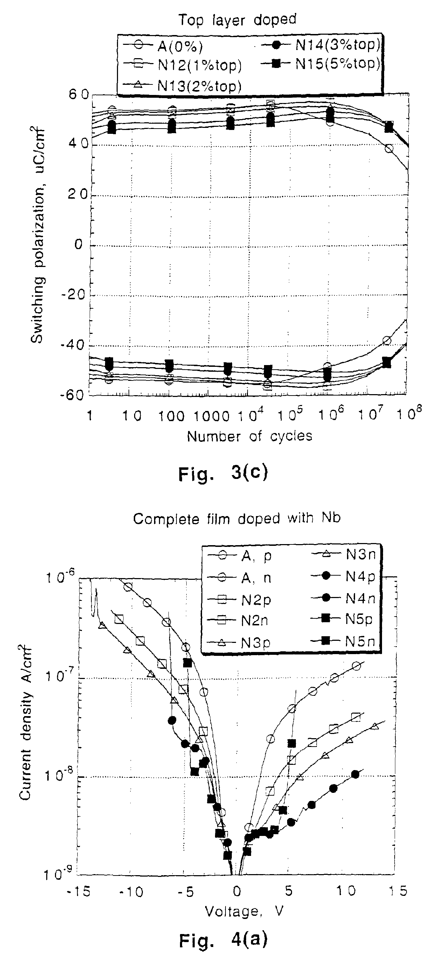

Figures 3a to 3c show the variation of the switching polarization in dependence of the number of cycles effected on the respective sample. Here a marked difference between bulk-doped and asymmetrically doped samples is manifest. The switching polarization of the bulk-doped samples (Fig. 3a), already significantly reduced from the beginning, also decreases more quickly and more strongly than that of the undoped sample or the asymmetrically doped samples (Figs. 3b, 3c). Indeed, some of the asymmetrically doped samples show a stronger resistance to polarization suppression than the undoped film.

### Leakage conduction properties

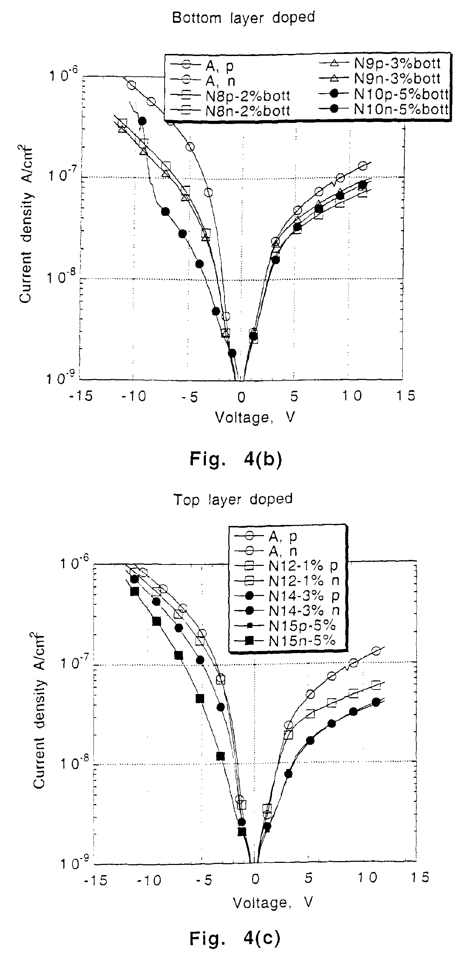

Figure 4a shows the I-V curves for the bulk-doped samples. The 0.5%-doped sample, N1, is omitted as the results hardly differ from the undoped reference. A reduction of leakage conduction is observed with every other sample, though the samples with more than 3%Nb are susceptible to premature breakdown. At 2%Nb, no such breakdown occurs, and conduction is reduced by a factor of about five.

As evidenced in Figures 4b and 4c, the asymmetrically doped films show a less-marked improvement in leakage resistance. Here, the leakage conduction is reduced by a factor of between two and three. On the other hand, there is only one incident of premature breakdown, at 5%Nb bottom-layer doping.

### Breakdown

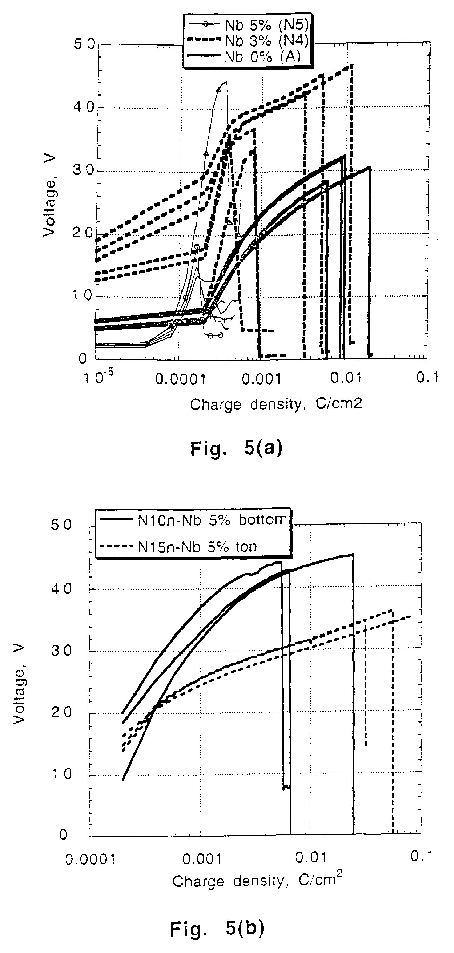

The breakdown voltage-charge curves are shown in Figures 5a and 5b. Figure 5a shows the behavior of the bulk-doped samples, where the breakdown limit obviously strongly depends on the Nb concentration, as the 5%Nb-doped sample breaks much earlier than the 3%-doped sample, which is in turn surpassed by the undoped film.

Figure 5b presents the breakdown curve for the 5%Nb asymmetrically doped samples, and it is clear from comparison with Figure 5a that their resistance to breakdown is on a par with that of the undoped sample. The strength of the top-doped sample is impressive.

Occasional failures at very low charge or at the outset of the measurement were attributed to extrinsic breakdown and therefore not included in the graphs.

### Summary of Measurements

The measurements show a lower leakage conduction for Nb-doped PZT thin films, whether the doping is throughout the film or asymmetrical, this conduction reduction being more pronounced for the bulk-doped samples than for those asymmetrically doped. However, the resistance to both polarization switching suppression and breakdown of the asymmetrically doped samples is nearly equivalent to that of the undoped film, while the bulk-doped samples are manifestly weaker.

The results show that the presence of niobium decreases the leakage conduction in PZT thin films. This decrease is roughly proportional to the amount of dopant for any given dopant distribution and higher for bulk-doped samples than for interface-doped samples of the same dopant percentage. However, this effect is not nearly as high as one should expect for a pure bulk-controlled conduction mechanism, and a bulk-controlled conduction model is unable to explain the asymmetrical leakage for the asymmetrically doped PZT films. The presented results on leakage conduction attest conduction controlled by injection over the blocking interface. For such mechanism, dopants impact leakage conduction due to redistribution of electric field in the ferroelectric film.

The results obtained from the fatigue testing show a marked difference between bulk-doped samples and asymmetrically doped samples. While the former performed poorly for higher dopant concentrations, showing a slimmer hysteresis loop from the beginning and fatiguing earlier, the latter performed nearly as well as the undoped sample even up to the highest dopant concentration. Since the asymmetrically doped samples resist fatigue nearly as well as the undoped film, it is reasonable to assume that one non-degraded interface is sufficient to nucleate opposite domain centers and thereby initiate switching. This is corroborated by results in articles "Degradation of Asymmetrical Pt/SRO/PLZT/Pt Capacitors: Role of Pt and Oxide Electrodes" by I. Stolichnov et al, in Integrated Ferroelectrics, 1999, Vol. 26, pp311-321, and "Top-Interface-Controlled Switching and Fatigue Endurance of (Pb,La)(Zr,Ti)O₃ Ferroelectric Capacitors", also by Stolichnov et al, in Applied Physics Letters, Volume 74, Number 23, 7 June 1999. These articles describe PLZT capacitors of asymmetric structure where the ferroelectric switching and fatigue properties are controlled by the top SRO interface, whereas the degradation properties of the bottom Pt interface play a minor role.

### Conclusions

The presented results demonstrate that asymmetrical Nb doping can substantially improve leakage conduction resistance without deterioration of switching polarization and fatigue performance. Moreover, breakdown measurements indicate that the reliability of asymmetrically doped PNZT films is equal (and might exceed) that of undoped PZT thin films for resistance to breakdown. According to the results above, the advantages of asymmetrical Nb doping are as follows: reduced leakage conduction along with good resistance both to repeated polarization cycling and to dielectric breakdown. In addition, selective doping can be of interest for reduction of polarization imprint and improvement of retention degradation of switching polarization. From this point of view, selective Ca+Sr doping as described in US Patent 5,969,935 can be of particular interest.

The reported testing on PNZT films is given to illustrate but not to limit the invention, many variations being possible within the scope of the appended claims.

## Claims

1. A ferroelectric film capacitor structure comprising a layer of doped ferroelectric material between facing electrodes, the concentration of the dopant in the ferroelectric material varying as a function of the distance from the electrodes.

2. The structure of claim 1, wherein the ferroelectric material is (Pb)(Zr,Ti)O₃ (PZT).

3. The structure of claim 1 or 2, wherein the dopant is selected from Nb, Ta, La, Sr, Ca and combinations thereof.

4. The structure of claim 1, 2 or 3, wherein the concentration of dopant decreases near one interface of the ferroelectric film.

5. The structure of claim 1, 2 or 3, wherein the concentration of dopant decreases near both interfaces of the ferroelectric film.

6. The structure of any preceding claim, wherein the concentration of dopant varies, as a function of the distance from the electrodes, in the range 0 to 15% by weight of the ferroelectric material.

7. The structure of any preceding claim, wherein the ferroelectric material is composed of a plurality of film layers, each film layer containing no dopant or a selected quantity of the dopant such that the concentration of the dopant in the resulting ferroelectric material varies as a function of the distance from the electrodes.

8. A memory cell comprising a plurality of interconnected structures according to any preceding claim.

9. A method of producing a ferroelectric film capacitor structure, which structure comprises a layer of doped ferroelectric material between facing electrodes, the method comprising depositing the ferroelectric material from different precursors in several film layers, each film layer containing no dopant or a selected quantity of the dopant such that the concentration of the dopant in the resulting ferroelectric material varies as a function of the distance from the electrodes.
